# EUROPEAN PATENT SPECIFICATION

(11) **EP 3 764 763 B1**
(45) Date of publication and mention of the grant of the patent: **06.08.2025**
(21) Application number: 18909246.3
(22) Date of filing: 07.03.2018
(51) Int. Cl.: H05K 13/04, H05K 13/08

(54) **COMPONENT MOUNTING SYSTEM**
KOMPONENTENMONTAGESYSTEM
SYSTÈME DE MONTAGE DE COMPOSANT

(43) Date of publication of application: 13.01.2021
(73) Proprietor: Fuji Corporation, Chiryu-shi, Aichi 472-8686 (JP)
(72) Inventor: MIZUNO, Toshiaki, Chiryu-shi, Aichi 472-8686 (JP); SHIMOSAKA, Kenji, Chiryu-shi, Aichi 472-8686 (JP); IBE, Tadakatsu, Chiryu-shi, Aichi 472-8686 (JP)
(74) Representative: Grünecker Patent- und Rechtsanwälte PartG mbB
(86) International application number: PCT/JP2018/008685
(87) International publication number: WO 2019/171481

(56) References cited:
- WO-A1-2016/189684
- WO-A1-2016/189684
- JP-A- 2006 196 618
- JP-A- 2014 067 860
- JP-A- 2016 025 131
- JP-A- H10 224 088

## Description

### Technical Field

The present invention relates to a component mounting system comprising a holding tool for holding a component and a moving device for moving the holding tool.

### Background Art

A component mounting system includes a holding tool for holding a component and a moving device for moving the holding tool, and a component held by the holding tool is mounted on a board or the like by controlling the operation of the moving device. Patent Literature below describes an example of such a component mounting system. Patent Literature 2 and Patent Literature 3 provide further component mounting system according to the prior art.

### Patent Literature

Patent Literature 1: JP-A-2004-186382
Patent Literature 2: JP-A-2006-196618
Patent Literature 3:WO- 2016189684

### Summary of the Invention

### Technical Problem

The object of the present invention is to provide a component mounting system capable of properly mounting components.

### Solution to Problem

The invention is set out in the appended set of claims. In order to solve the above problems, the present specification discloses a component mounting system comprising: a holding tool configured to hold a component; a moving device configured to move the holding tool; an electromagnetic motor for lowering the holding tool in order to mount the component on a board; a detection sensor configured to detect contact of a component held in the holding tool with a board; and a control device, performing a first mounting operation and a second mounting operation selectively, wherein the first mounting operation is an operation in which a component held by the holding tool is mounted on the board while executing foreign matter detection for detecting with the sensor whether there is foreign matter present at a planned mounting position, and the second mounting operation is an operation in which a component held by the holding tool is mounted on the board without executing the foreign matter detection, and wherein, in the foreign matter detection an actual component height of the component is calculated based on a detected value of an encoder of the electromagnetic motor, a target component height is set in advance based on the height dimensions of the component and the component mounting system is configured such that, if the detection sensor detects that a member has come in contact with the component, before actual component height is lowered to target component height, it is determined that foreign matter is present at the planned mounting position on the board, and with respect to the mounting operation for each of the components, the control device further is configured to control the lowering speed of the holding tool so as to mount the component to the board such that the time required for the first mounting operation is longer than the time required for the second mounting operation.

Further, in order to solve the above problems, the present specification discloses a component mounting system comprising: a holding tool configured to hold a component; a moving device configured to move the holding tool; an electromagnetic motor for lowering the holding tool in order to mount the component on a board; a detection sensor configured to detect contact of a component held in the holding tool with a board; and a control device, performing a first mounting operation and a second mounting operation selectively, wherein the first mounting operation is an operation in which a component held by the holding tool is mounted on the board while executing foreign matter detection for detecting with the sensor whether there is foreign matter present at a planned mounting position, and the second mounting operation is an operation in which a component held by the holding tool is mounted on the board without executing the foreign matter detection, and wherein, in the foreign matter detection an actual component height of the component is calculated based on a detected value of an encoder of the electromagnetic motor, a target component height is set in advance based on the height dimensions of the component and the component mounting system is configured such that, if the detection sensor detects that a member has come in contact with the component, before actual component height is lowered to target component height, it is determined that foreign matter is present at the planned mounting position on the board, and with respect to the production work of the same board type, the control device is configured to control the lowering speed of the holding tool such that the time required for the production work of the board using the first mounting operation is longer than the time required for the production work of the board using the second mounting operation.

### Advantageous Effect of the Invention

According to the present disclosure, a first mounting operation and a second mounting operation are selectively performed, the first mounting operation being an operation in which a mounting operation is performed while executing foreign matter detection, and the second mounting operation being an operation in which a mounting operation is performed without executing foreign matter detection. With respect to the mounting operation for one component, the time required for the first mounting operation is longer than the time required for the second mounting operation. Alternatively, with respect to the production of the same board type, the time required to produce a board using the first mounting operation is longer than the time required to produce a board using the second mounting operation. Thus, it is possible to properly determine whether there is foreign matter present at the planned mounting position and properly perform the mounting operation for the components.

### Brief Description of Drawings

[Fig. 1] A perspective view showing a component mounting machine.
[Fig. 2] A perspective view showing a component mounting device of the component mounting machine.
[Fig. 3] A side view showing a part of a work head.
[Fig. 4] A block diagram showing a control device.
[Fig. 5] A view showing mounting work on a circuit substrate without foreign matter.
[Fig. 6] A view showing mounting work on a circuit substrate with foreign substance.
[Fig. 7] A table showing the relationship between the lowering speed, the lowering acceleration, and the detected height of the work head.
[Fig. 8] A graph showing the relationship between the lowering speed, the lowering acceleration, and the detected height of the work head.
[Fig. 9] A view showing a mounting operation on a warped circuit substrate.
[Fig. 10] A schematic view showing measurement positions for the height of circuit substrate.

### Description of Embodiments

Hereinafter, an embodiment of the present invention will be described in detail with reference to the drawings.

### (A) Configuration of the component mounting machine

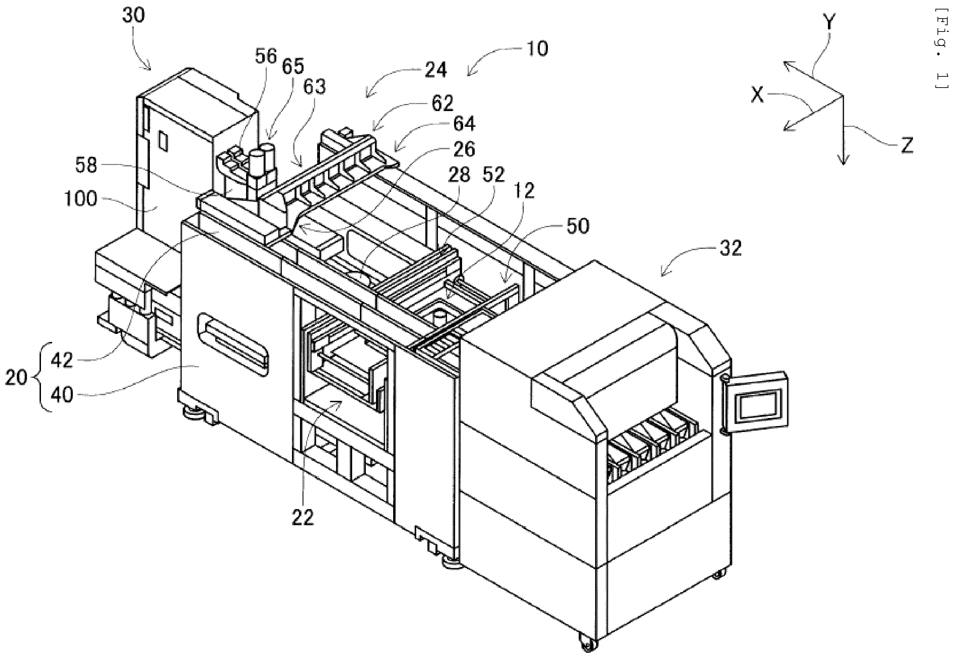

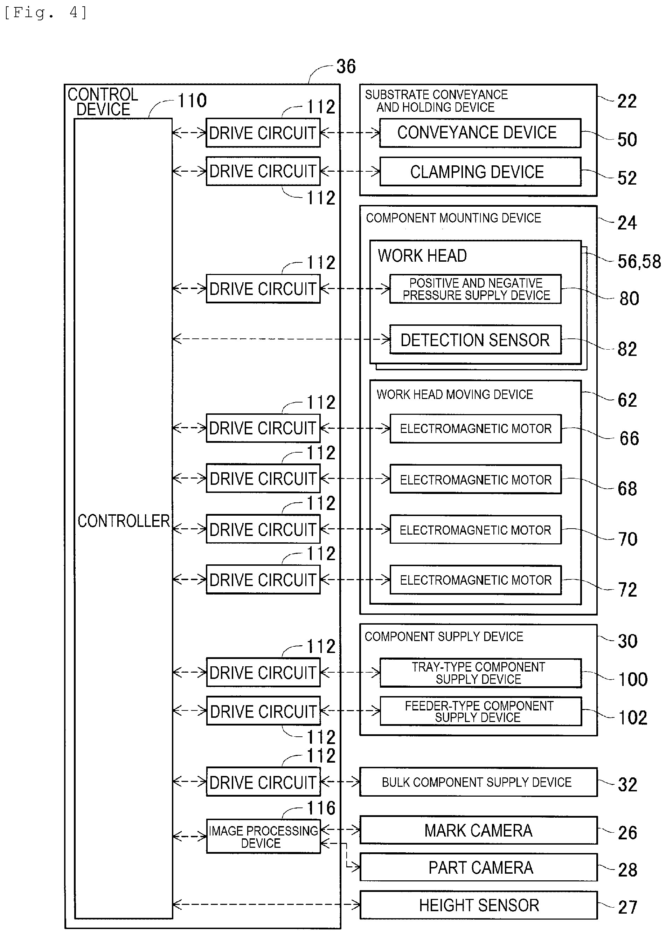

Fig. 1 shows component mounting machine 10. Component mounting machine 10 is a device for mounting components on circuit substrate 12. Component mounter 10 includes device main body 20, substrate conveyance and holding device 22, component mounting device 24, mark camera 26, height sensor 27, part camera 28, component supply device 30, bulk component supply device 32, and control device (refer to Fig. 4) 36. Circuit substrate 12 may be a circuit board, or a substrate or the like having a three-dimensional structure, and the circuit board may be a printed wiring board, a printed circuit board, or the like.

Device main body 20 includes frame section 40 and beam section 42 mounted on frame section 40. Board conveyance and holding device 22 is provided at the center of frame section 40 in the front-rear direction and has conveyance device 50 and clamping device 52. Conveyance device 50 is a device for conveying circuit substrate 12, and clamping device 52 is a device for holding circuit substrate 12. With this configuration, substrate conveyance and holding device 22 conveys circuit substrate 12 and fixedly holds circuit substrate 12 at a predetermined position. In the following description, the conveyance direction of circuit substrate 12 is referred to as the X-direction, the horizontal direction perpendicular to the direction is referred to as the Y-direction, and the vertical direction is referred to as the Z-direction. In other words, the width direction of component mounting machine 10 is the X-direction, and the front-rear direction is the Y-direction.

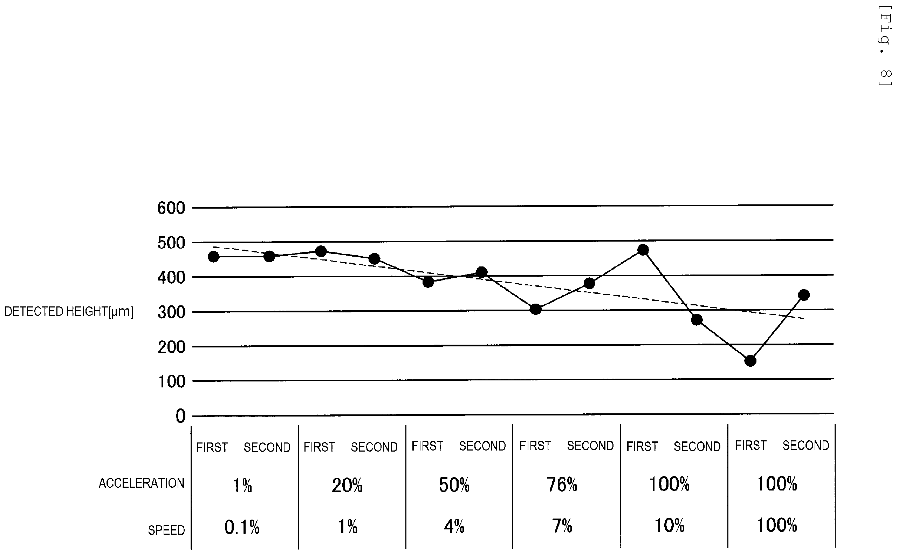

Component mounting device 24 is disposed on beam section 42 and has two work heads 56, 58 and work head moving device 62. Work head moving device 62 is composed of X-direction moving device 63, Y-direction moving device 64, and Z-direction moving device 65. X-direction moving device 63 and Y-direction moving device 64 include electromagnetic motors (refer to Fig. 4) 66, 68, respectively, whereby two work heads 56, 58 are integrally moved to any position on frame section 40 by corresponding electromagnetic motors 66, 68. Z-direction moving device 65 includes electromagnetic motors (refer to Fig. 8) 70, 72, whereby sliders 74, 76 are individually moved in the up-down direction by corresponding electromagnetic motors 70, 72. Work heads 56, 58 are detachably attached to slider 74, 76. As a result, work heads 56, 58 are moved individually in the up-down direction by Z-direction moving device 65.

Further, each of work heads 56, 58 mount components on circuit substrates 12 and has suction nozzle 78 provided on the lower end. Suction nozzle 78 communicates with positive and negative pressure supply device (refer to Fig. 4) 80 via negative pressure air and positive pressure air passages. Suction nozzle 78 picks up and holds electronic components by negative pressure and releases electronic components held by positive pressure. Work heads 56, 58 also include detection sensor 82 for detecting contact of a component held by suction nozzle 78 with circuit substrate 12.

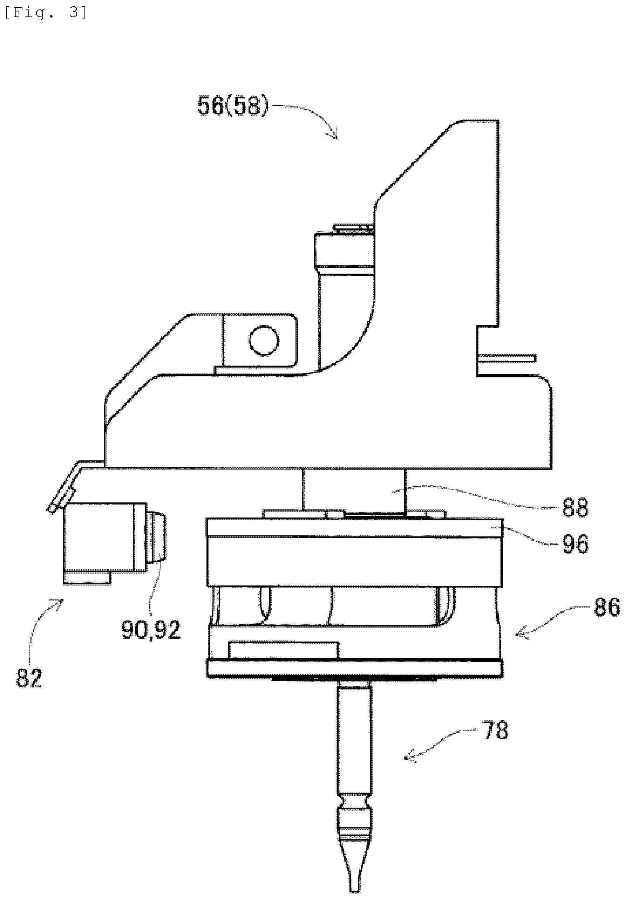

Specifically, as shown in Fig. 3, each of work heads 56, 58 has holder 86, having a generally cylindrical shape, holder 86 being held in the up-down direction in a slidable manner by holding shaft 88 at the lower portion of work heads 56, 58. Holder 86 is biased downward with respect to the work head by a compression coil spring (not shown). However, the downward biasing of holder 86 is restricted at a predetermined position with a stopper (not shown). Suction nozzle 78 is detachably held by holder 86. With such a configuration, suction nozzle 78 is held by the lower face of work heads 56, 58 in a manner so as to be pushed upward.

Detection sensor 82 is a non-contact-type photoelectric sensor and includes irradiation section 90 and light receiving section 92, with light irradiated from irradiation section 90 being reflected off the side surface of holder 86, and light receiving section 92 receiving the reflected light. Flange portion 96 is formed on the upper portion of the side surface of holder 86, and the side surface of holder 86 is a stepped surface. When holder 86 has slid to the lowest point, light irradiated from irradiation section 90 is irradiated to flange portion 96 of holder 86.

Therefore, the detected value by detection sensor 82 is different in the case where light irradiated from irradiation section 90 is reflected off flange 96 while holder 86 is positioned at the lowest point and in the case where light irradiated from irradiation section 90 is reflected off flange portion 96 while holder 86 is slid upward due to the differences in detected height. That is, as a result of suction nozzle 78, held by holder 86, being pushed upward by a predetermined amount from the lowest sliding point,
the point irradiated from irradiation section 90 to the side surface of holder 86 moves downward from flange portion 96 and the detection value of detection sensor 82 changes. With such a structure, when a component held by suction nozzle 78 comes in contact with circuit substrate 12, the compression coil spring is further compressed and detection sensor 82 detects the fact that suction nozzle 78 has been pushed upward by a predetermined amount from the lowest sliding point. That is, detection sensor 82 detects contact of the component held by suction nozzle 78 with circuit substrate 12. With this, as will be described in detail later, when mounting a component held by suction nozzle 78 to circuit substrate 12, lowering of work head 56, 58, that is, the operation of electromagnetic motors 70, 72 of Z-direction moving device 65 is controlled in consideration of, for example, the operating speed, the operating acceleration, or the operating time.

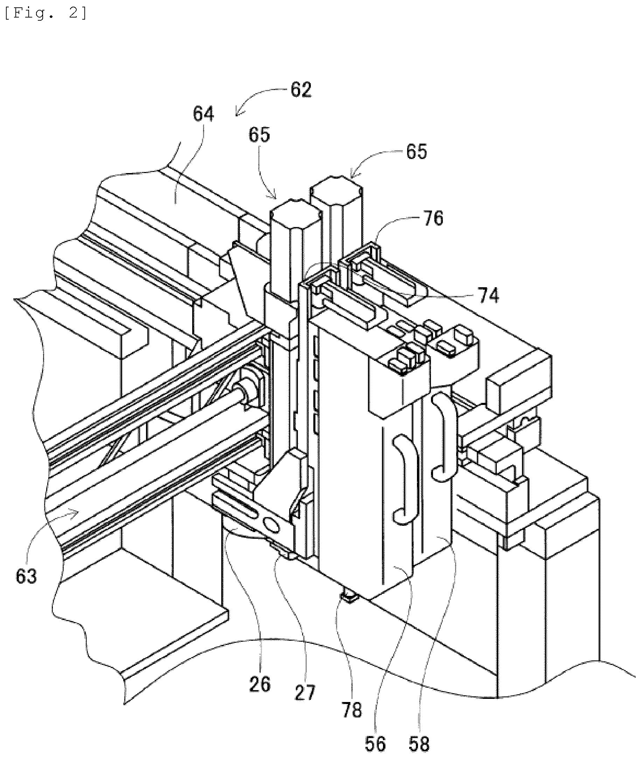

Mark camera 26 is attached to slider 74 while being oriented downward as shown in Fig. 2 and is caused to move in the X-direction, Y-direction and Z-direction together with work head 56. Thus, mark camera 26 is moved to any position by the operation of work head moving device 62, and mark camera 26 images any position on frame section 40.

Further, height sensor 27 is also attached to slider 74. Height sensor 27 is a length measuring sensor of the laser-beam reflection type and detects the height of circuit substrate 12 using a laser beam. That is, height sensor 27 is moved to a position above circuit substrate 12 held in clamping device 52 by the operation of work head moving device 62. Height sensor 27 is then irradiates circuit substrate 12 with the laser beam and receives the beam reflected off circuit substrate 12. Thus, the distance between circuit substrate 12 and height sensor 27 is the measured length, and the height of any position of circuit substrate 12 is detected.

Part camera 28 is disposed between substrate conveyance and holding device 22 and component supply device 30 on frame section 40 while being oriented upwards, as shown in Fig. 1. Thus, work heads 56, 58 holding a component are moved to a position above component camera 28 by the operation of work head moving device 62 enabling part camera 28 to image the component held by suction nozzle 78.

Further, component supply device 30 is disposed at one end of frame section 40 in the front-rear direction. Component supply device 30 has tray-type component supply device 100 and feeder-type component supply device (refer to Fig. 4) 102. Tray-type component supply device 100 is a device configured to supply components placed on a tray. Feeder-type component supply device 102 is a device for supplying components with a tape feeder or a stick feeder (not shown).

Bulk component supply device 32 is provided at the other end of frame section 40 in the front-rear direction. Bulk component supply device 32 is a device for aligning multiple scattered components and supplying the components in an aligned state. That is, bulk component supply device 32 is a device for aligning multiple components in any orientation into a predetermined orientation and supplying the components in the predetermined orientation.

As shown in Fig. 4, control device 36 includes controller 110, multiple drive circuits 112, and image processing device 116. Multiple drive circuits 112 are connected to conveyance device 50, clamping device 52, electromagnetic motors 66, 68, 70, 72, positive and negative pressure supply device 80, tray-type component supply device 100, feeder-type component supply device 102, and bulk component supply device 32. Controller 110 includes a CPU, ROM, RAM, and the like, mainly consists of a computer, and is connected to multiple driving circuits 112. Accordingly, the operations of substrate conveyance and holding device 22, component mounting device 24, and the like are controlled by controller 110. Controller 110 is also connected to image processing device 116. Image processing device 116 processes image data obtained by mark camera 26 and part camera 28, and controller 110 acquires various types of information from the image data. Furthermore, controller 110 is also connected to detection sensor 82, height sensor 27, and acquires and calculates detection values from detection sensor 82 and height sensor 27.

### (B) Operation of the component mounting machine

Being configured as described above, component mounter 10 mounts electronic components on circuit substrate 12 held by substrate conveyance and holding device 22. Specifically, circuit substrate 12 is conveyed to a work position and is fixedly held by clamping device 52 at the position. Next, mark camera 26 moves to a position above circuit substrate 12 and images circuit substrate 12. Then, controller 110 calculates the error or the like of the position at which circuit substrate 12 is held by clamping device 52 based on the imaging data.

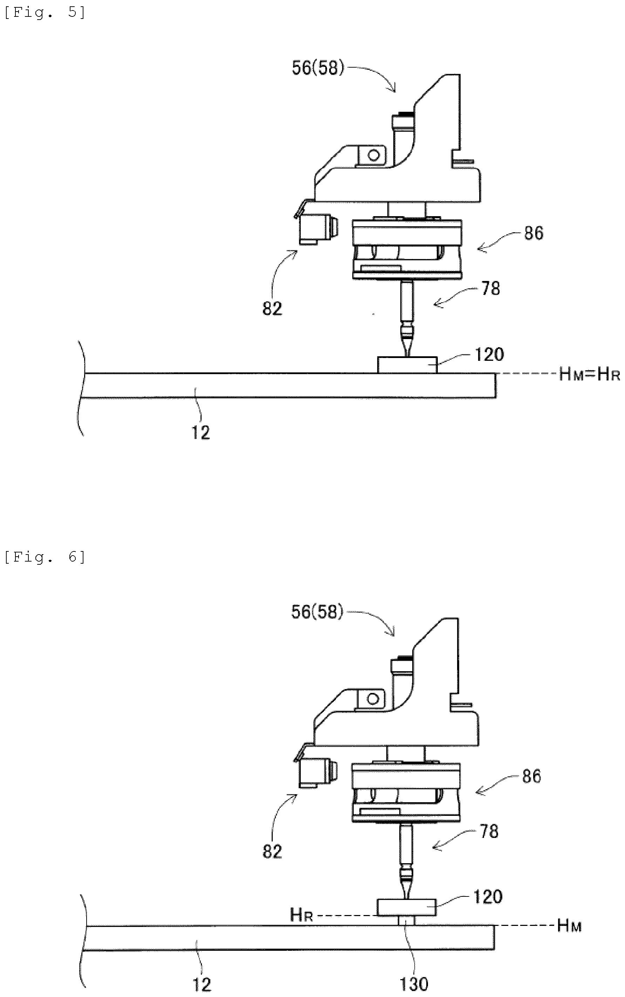

Further, component supply device 30 or bulk component supply device 32 supplies electronic component (refer to Fig. 5) 120 to a predetermined supply position. Then, either one of work heads 56, 58 is moved to a position above the supply position of the component, and by lowering work head 56/58, suction nozzle 78 attached to work head 56/58 picks up and holds electronic component 120.

Next, work head 56/58 moves to a position above part camera 28, and electronic component 120 held by suction nozzle 78 is imaged by part camera 28. Then, controller 110 calculates the orientation and the like of electronic component 120 held in suction nozzle 78 based on the imaging data. Then, work head 56/58 for holding electronic component 120 is moved to a position above circuit substrate 12, and by lowering work head 56/58, the error in the holding position of circuit substrate 12, the error in the holding orientation of the component, and the like are corrected, and the held component is mounted onto circuit substrate 12.

When this occurs, in order to mount electronic component 120 held by work head 56/58 onto the upper face of circuit substrate 12, the driving source for lowering work head 56/58, that is, the operation of electromagnetic motors 70, 72 of Z-direction moving device 65 are controlled based on the detection value by detection sensor 82. Specifically, electromagnetic motor 70/72 performs position control in accordance with the detected value of the encoder, and at the time of operation of electromagnetic motor 70/72, the actual height of electronic component 120 held by work head 56/58, which is the height of the lower face of electronic component 120, (hereinafter, referred to as "actual component height H_{R}") is calculated based on the detected value of the encoder. On the other hand, along the Z-axis coordinate of the mounting position on the upper face of circuit substrate 12, that is, the mounting height that is the target for electronic component 120 (hereinafter, referred to as "target component height H_{M}") is set in advance based on the height dimensions and the like of electronic component 120. Target component height H_{M} is set to be located slightly below the Z-axis coordinate of the upper face of circuit substrate 12.

However, in order to ensure proper mounting of electronic component 120 onto circuit substrate 12, the detection value by detection sensor 82 is used. Specifically, due to errors and the like in the dimensions of electronic component 120, even if actual component height H_{R} decreases to target component height H_{M}, there is a possibility that electronic component 120 held by suction nozzle 78 will not come in contact with the upper face of circuit substrate 12. When holding of electronic component 120 by suction nozzle 78 is released in such a state, electronic component 120 cannot be properly mounted on circuit substrate 12.

Therefore, even after actual component height H_{R} is lowered to target component height H_{M}, the operation of electromagnetic motor 70/72 is not stopped and work head 56/58 is further lowered. Electronic component 120 held by suction nozzle 78 then comes in contact with the upper face of circuit substrate 12, and the contact of electronic component 120 with circuit substrate 12 is detected by detection sensor 82. Then, at a predetermined timing at which the contact of electronic component 120 with circuit substrate 12 is detected by detection sensor 82, the operation of electromagnetic motor 70/72 is stopped. That is, although the operation of electromagnetic motor 70/72 is controlled so that actual component height H_{R} is lowered to target component height, if actual component height H_{R} has not descended to target component height H_{M}, the operation of electromagnetic motor 70/72 does not stop. Then, with the detection by detection sensor 82 of electronic component 120 coming in contact with circuit substrate 12 serving as a trigger, the operation of electromagnetic motor 70/72 stops.

Then, when the operation of electromagnetic motor 70/72 has stopped, a slight positive pressure is supplied to suction nozzle 78 to separate electronic component 120 from suction nozzle 78. Thus, with the operation of electromagnetic motor 70/72 of Z-direction moving device 65 being controlled based on the detection value from detection sensor 82, the holding of electronic component 120 by suction nozzle 78 is released while electronic component 120 is in contact with circuit substrate 12. As a result, proper mounting of electronic component 120 to circuit substrate 12 is ensured. In order to shorten the cycle time, the electromagnetic motor 70/72 at the time of mounting electronic component 120 is operated at an output operating speed near or at the maximum output speed of electromagnetic motor 70/72, and the moving speed of the holding tool for mounting electronic components is set specifically to a maximum speed of approximately 500 mm/sec (approximately 2G when converted to acceleration).

In addition, in component mounting machine 10, it is possible to perform foreign matter detection in which it is determined by detection sensor 82 whether there is foreign matter at the planned mounting position when executing a mounting operation. Specifically, for example, as shown in Fig. 6, when foreign matter 130 is present at the planned mounting position, electronic component 120 will be mounted on top of foreign matter 130 when the mounting operation of electronic component 120 is executed. In such a case, during the operation control of electromagnetic motor 70, 72, before actual component height H_{R} is lowered to target component height H_{M}, electronic component 120 held by suction nozzle 78 comes in contact with foreign matter 130, and by the contact, detection sensor 82 detects that some member has come in contact with electronic component 120. Thus, before actual component height H_{R} is lowered to target component height H_{M}, if detection sensor 82 detects that some member has come in contact with electronic component 120 held by suction nozzle 78, it is likely that foreign matter 130 or a fallen component is present at the planned mounting position.

Therefore, in such a case, that is, if contact of electronic component 120 with some member is detected by detection sensor 82 before actual component height H_{R} is lowered to target component height H_{M}, electronic component 120 held by suction nozzle 78 is not released. That is, electronic component 120 is not mounted on circuit substrate 12. Electronic component 120 held by suction nozzle 78 is then discarded in a waste box or the like, and the mounting operation of electronic component 120 is skipped. Thus, it is possible to prevent mounting of electronic component 120 on foreign matter 130. Skipping of the mounting operation, the presence of foreign matter 130, and the like are displayed on a panel device, and this fact is notified to the operator, and various actions are executed by the operator.

It should be noted that when the mounting operation is performed while the foreign matter detection is performed, the time required for the mounting operation per component is increased in the mounting operation of electronic component 120 as compared with the case where the mounting operation is performed without foreign matter detection. That is, as compared with the case where the mounting work is performed without executing foreign matter detection, the time required for the production operation of circuit substrate 12 is increased when the mounting operation is performed while executing foreign matter detection. In addition, in the case where a multiple of the same substrate type is produced, boards produced by performing the mounting operation while executing foreign matter detection takes longer to produce than boards produced by performing the mounting operation without executing foreign matter detection. More specifically, when a mounting operation is performed while foreign matter detection is performed, the lowering speed and lowering acceleration of work head 56/58, that is, the operating speed and operating acceleration of electromagnetic motor 70/72 at the time of the mounting operation are limited to be low as compared with the case where the mounting operation is performed without foreign matter detection. This is because the faster work head 56/58 is lowered, the lower the detection accuracy of detection sensor 82.

Specifically, as mounting target electronic component 120, a component is used having a mounting surface that is flat with component dimensions being 42.9 mm square, and foreign matter 130 is placed in the center of the planned mounting position of the component. Incidentally, the size of foreign matter 130 is 1005c of an electronic component, that is, 1 mm in width × 0.5 mm in height. Then, the operation of electromagnetic motor 70/72 is controlled so that actual component height H_{R} becomes target component height H_{M}, and actual component height H_{R} at the time at which electronic component 120 comes in contact with circuit substrate 12 is determined by detection sensor 82. The difference between the specified actual component height H_{R} and target component height H_{M} is calculated as the detected height by detection sensor 82. In addition, by changing the lowering speed and the lowering acceleration of work head 56/58, the height is calculated twice in each of six operating modes: an operating mode at the maximum output (100% speed, 100% acceleration) of electromagnetic motor 70/72; an operating mode at the output (10% speed, 100% acceleration) that suppresses the speed to 10%; an operating mode at the output (7% speed, 76% acceleration) that suppresses the speed to 7% and acceleration to 76%; an operating mode at the output (4% speed, 50% acceleration) that suppresses the speed to 4% and acceleration to 50%; an operating mode at the output (1% speed, 20% acceleration) that suppresses the speed to 1% and acceleration to 20%; and an operating mode at the output (0.1% speed, 0.1% acceleration) that suppresses the speed to 0.1% and acceleration to 1%.

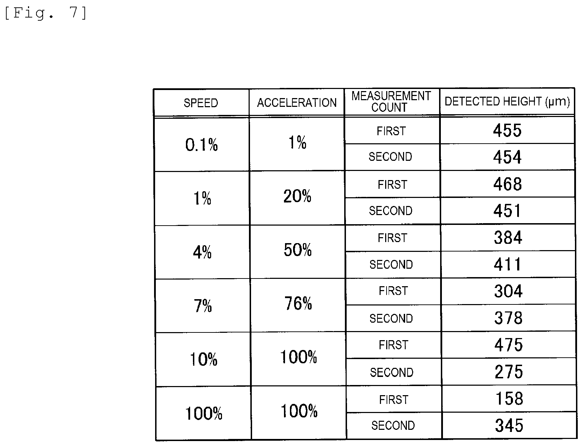

The results of comparing the detected heights (µm) for each of the six operating modes are shown in Figs. 7 and 8. As can be seen, the more the speed and acceleration are suppressed, that is, the slower the lowering speed and lowering acceleration of work heads 56, 58, the higher the detected height (µm), and the faster the lowering speed and lowering acceleration of work heads 56, 58, the lower the detected height (µm). Further, the slower the lowering speed and lowering acceleration of work heads 56/58, the smaller the variation in the detected height (µm), while the faster the lowering speed and lowering acceleration of work head 56/58, the larger the variation in the detected height (µm). That is, the lower the lowering speed and lowering acceleration of work head 56/58, the higher the detection accuracy of detection sensor 82, and the faster the lowering speed and lowering acceleration of work head 56/58, the lower the detection accuracy of detection sensor 82. Specifically, for example, in the operation mode with an output in which the speed and acceleration were suppressed to 0.1% and 1%, respectively, the height of foreign matter 130 having a height of 0.5 mm (500 µm) can be detected with an accuracy of about 450 µm. On the other hand, in the operating mode at the maximum output (speed 100%, acceleration 100%), foreign matter 130 having a height of 0.5 mm (500 µm) can only be detected with an accuracy of about 150 µm.

Further, the further foreign matter 130 is placed toward the edge of the planned mounting position instead of the center of the planned mounting position, the more the detection accuracy of foreign matter 130 is reduced. Specifically, for example, when foreign matter 130 is in the center of the planned mounting position, in the operation mode with an output that suppresses the speed to 0.1 % and acceleration to 1%, the height of foreign material 130 having a height of 0.5 mm (500 µm) could be detected with an accuracy of about 450 µm. On the other hand, when foreign matter 130 is offset 20 mm from the center of the planned mounting position, even in the operation mode with an output that suppresses the speed to 0.1 % and acceleration to 1%, the height of foreign matter 130 having a height of 0.5 mm (500 µm) can only detected with an accuracy of about 350 µm.

Therefore, when the mounting operation is performed while performing foreign matter detection, it is necessary to limit the lowering speed and lowering acceleration of work head 56/58 during the mounting operation. However, when the lowering speed and lowering acceleration of work head 56/58 during the mounting operation are limited, it is preferable that the lowering speed and lowering acceleration limits be small since the mounting time and, in turn, the cycle time cannot be shortened.

Therefore, the operator can freely set the limits of the lowering speed and lowering acceleration to find a balance between the detection accuracy of detection sensor 82, that is, the detection accuracy of foreign matter 130 and the cycle time. That is, if the operator gives priority to shortening the cycle time, the lowering speed and lowering acceleration of work head 56/58 are set so as to reduce the limits of the lowering speed and lowering acceleration, and if the operator gives priority to the detection accuracy of foreign matter 130, the lowering speed and lowering acceleration of work head 56/58 are set so as to increase the limits of the lowering speed and lowering acceleration. As a result, it is possible to strike a balance between the detection accuracy of foreign matter 130 and the cycle time in accordance with the conditions of the mounting operation and the contents of the operation.

That is, in component mounting machine 10, the mounting operation while executing foreign matter detection (hereinafter, referred to as the "first mounting operation") and the mounting operation without executing foreign matter detection (hereinafter, referred to as the "second mounting operation") can be selectively executed. In the second mounting operation, it is possible to reduce the cycle time by operating electromagnetic motors 70, 72 at or near the maximum output which are set in advance so as not to affect the mounting operation or the mounting accuracy with vibrations generated by the mounting operation. On the other hand, in the first mounting operation, it is possible to detect foreign matter 130 by controlling the operation output of electromagnetic motor 70/72, although the cycle time will increase. Furthermore, in the first mounting operation, since the operation output of electromagnetic motors 70, 72 can be arbitrarily set, it is possible to balance the detection accuracy of foreign matter 130 and the cycle time. These can be set according to the type of component to be mounted and the type of board to be produced.

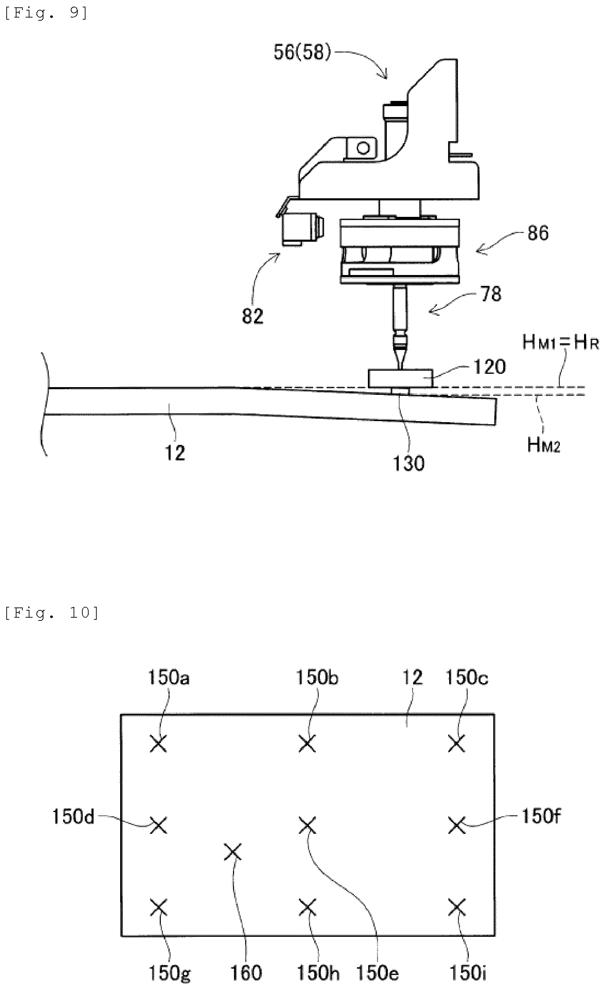

In the first mounting operation, foreign matter detection is performed to address the detection accuracy of foreign matter 130 in consideration of warping or the like of circuit substrate 12. Specifically, for example, as shown in Fig. 9, regardless of warping in circuit substrate 12, without considering the warping of circuit substrate 12, when the target component height is set, even though circuit substrate 12 is warped downward, the target component height may be set to H_{M1}. Thus, the target component height is set to H_{M1}, and when the operation of electromagnetic motor 70/72 is controlled so that actual component height H_{R} becomes target component height H_{M}, the detected value by detection sensor 82 is changed at the time at which actual component height H_{R} becomes target component height H_{M1}. That is, after actual component height H_{R} is lowered to target component height H_{M1}, the contact of electronic component 120 held by suction nozzle 78 is detected by detection sensor 82. Therefore, in such a case, as described above, it is determined that the foreign matter 130 is not present at the planned mounting position, and electronic component 120 is detached from foreign matter 130.

On the other hand, when the target component height is set, the target component height is set to H_{M2} (< H_{M1}) in consideration of the warping of circuit substrate 12. Thus, when the target component height is set to H_{M2}, the contact of electronic component 120 held by suction nozzle 78 is detected by detection sensor 82 before actual component height H_{R} is lowered to target component height H_{M2}. In such a case, as described above, it is determined that foreign matter 130 is present at the planned mounting position, and electronic component 120 is not detached.

Therefore, in component mounting machine 10, target component height H_{M} is set in consideration of the warping of circuit substrate 12. Specifically, when circuit substrate 12 is conveyed to the mounting operation position and positioned and held by clamping device 52, work head 56/58 move to a position above circuit substrate 12. Then, the height of circuit substrate 12 is detected by height sensor 27 attached to sliders 74/76 holding work head 56/58. When this occurs, as shown in Fig.10, the positions 150a-i of circuit substrate 12, such as being divided into nine segments, are measured by height sensor 27, and the heights of circuit substrate 12 at each measurement position 150a-i are detected. Then, for example, based on measurement positions 150d, e, g, h of the four sites surrounding planned mounting position 160, the height of circuit substrate 12 at planned mounting position 160 is calculated. Subsequently, target component height H_{M} is calculated based on the height of circuit substrate 12 at planned mounting position 160, the height of electronic component 120, or the like. Thus, target component height H_{M} is set in consideration of the warping of circuit substrate 12. Detection of foreign matter 130 can be properly performed even when such warping occurs in circuit substrate 12 by controlling the operation of electromagnetic motor 70/72 so that actual component height H_{R} becomes set target component height H_{M}.

Component mounting machine 10 is an example of a component mounting system. Height sensor 27 is an example of a detection device. Controller 36 is an example of a control device. Work head moving device 62 is an example of a moving device. Suction nozzle 78 is an example of a holding tool. Detection sensor 82 is an example of a detection sensor and a photoelectric sensor.

In addition, the present invention is defined by the appended claims and is not limited to the embodiments described above and can be carried out in various modes in which various modifications and improvements are made to the embodiments based on the knowledge of those skilled in the art to which the present invention pertains. Specifically, for example, in the above-described embodiment, a reflection-type photoelectric sensor having irradiation section 90 and light receiving section 92 is employed as detection sensor 82, but as long as the photoelectric sensor is a non-contact type photoelectric sensor, a radiation-type photoelectric sensor, a transmission-type photoelectric sensor, a reflector-type photoelectric sensor, or the like can be employed. A laser sensor, such as a height sensor, may be employed in place of the photoelectric sensor. Similarly, the present invention is not limited to a non-contact type photoelectric sensor, and a contact type sensor such as a probe may be used to detect the contact of electronic component 120 held by suction nozzle 78. However, since a contact type sensor may have problems with durability, response range, response accuracy, and response time, it is preferable to use a non-contact type sensor.

Further, in the above embodiment, when the first mounting operation is performed, the operating speed and operating acceleration of electromagnetic motor 70 are limited as compared with the case where the second mounting operation is performed, but only one of the operating speed and the operating acceleration of electromagnetic motor 70 may be limited. In this manner, even when only one of the operating speed and the operating acceleration of electromagnetic motor 70 is limited, the presence or absence of foreign matter 130 can be properly determined.

Further, in the above embodiment, the same components, that is, when the first mounting operation is performed at the time of mounting electronic component 120, as compared with the case where the second mounting operation is performed, the operating speed and the like of electromagnetic motor 70 are limited, and even if the components to be mounted in the first mounting operation and the second mounting operation are different, the operation speed and the like of electromagnetic motor 70 may be limited. That is, the operating speed and the like of the electromagnetic motor when mounting component A during the first mounting operation may be limited more than the operating speed and the like of the electromagnetic motor when mounting component B during the second mounting operation. However, since, in the case where dimensions of component A and component B are clearly different, generally, the bigger the component dimensions, the more limited is the operating speed and the like of the electromagnetic motor, the dimensions of component A and component B are substantially the same, that is, component A and component B are components of a group where the components have substantially the same size.

The attachment position of height sensor 27 is not limited to sliders 74, 76. Specifically, a moving body such as work heads 56/58 moving together with holder 86 may be fixedly attached to the path along which circuit substrate 12 is conveyed to the mounting work position. That is, it is sufficient to attach the moving body to a position at which the height at any position on the circuit substrate can be detected. For that purpose, multiple height sensors may be used, or a height sensor may be attached something that moves up and down provided the attachment position itself can also be detected.

Further, height sensor 27 may detect the planned mounting position itself instead of the position of circuit substrate 12.

Further, the downward biasing means of holder 86 is not limited to a compression spring. An air damper, various elastic members, a magnetic damper, or the like may be used as a biasing means. Further, a similar means as the operating head for vertically operating the holding shaft with the electromagnetic motor may be employed as a biasing means to control and manage the output of the electromagnetic motor as a biasing force.

In view of the above, the biasing means, which is an embodiment, can be eliminated. For example, the output value of the electromagnetic motor for vertically moving the work head with the holding shaft may be replaced as a biasing means that changes to a biasing force by controlling and managing to replace the biasing force. **In** other words, in the embodiment, although the work head is vertically operated by the electromagnetic motor, a similar concept can be adopted as long as the electromagnetic motor is a mechanism for vertically operating the suction nozzle. For example, to the operating axis of the Z-axis slide, a similar mechanism as the mechanism in the component mounting machine in which the Z-axis slide moves up and down can be applied.

**In** the above embodiment, the present invention is applied to the mounting operation of electronic component 120 held by suction nozzle 78, but may be applied to the mounting operation of electronic component 120 held by multiple gripping claws such as chucks.

### Reference Signs List

10: Component mounting machine (component mounting system), 27: Height sensor (detection device), 36: Control device, 62: Work head moving device (moving device), 78: Suction nozzle (holding tool), 82: Detection sensor (sensor)

## Claims

1. A component mounting system (10) comprising:
a holding tool (78) configured to hold a component (120);
a moving device (62) configured to move the holding tool (78);
an electromagnetic motor (70, 72) for lowering the holding tool (78) in order to mount the component (120) on a board (12);
a detection sensor (82) configured to detect contact of a component (120) held by the holding tool (78) with the board (12); and a control device (36), configured to perform a first mounting operation and a second mounting operation selectively, wherein
the first mounting operation is an operation in which a component (120) held by the holding tool (78) is mounted on the board (12) while executing foreign matter detection for detecting with the sensor (82) whether there is foreign matter present at a planned mounting position, and the second mounting operation is an operation in which a component (120) held by the holding tool (78) is mounted on the board (12) without executing the foreign matter detection, and wherein,
in the foreign matter detection an actual component height (HR) of the component (120) is calculated based on a detected value of an encoder of the electromagnetic motor (70, 72), a target component height (HM) is set in advance based on the height dimensions of the component (120) and
the component mounting system (10) is configured such that, if the detection sensor (82) detects that a member has come in contact with the component (10), before actual component height (HR) is lowered to target component height (HM), it is determined that foreign matter (130) is present at the planned mounting position on the board (120);
wherein with respect to the mounting operation for each of the components (120), the control device (36) is further configured to control the lowering speed of the holding tool (78) so as to mount the component (120) to the board (12) such that the time required for the first mounting operation is longer than the time required for the second mounting operation.

2. The component mounting system (10) of claim 1, wherein
the component mounting system (10) further comprises a detector (27) configured to detect a height at any position of the board (12), and wherein
the control device (36) utilizes the height of the board (12) detected by the detector (27) to perform the first mounting operation.

3. The component mounting system (10) of claim 1 or claim 2, wherein
the detection sensor (82) is a non-contact type sensor.

4. The component mounting system (10) of any one of claims 1 to 3, wherein
the control device (36) is configured to change the time required for the mounting operation of one component (120) of the holding tool (78) during the first mounting operation.

5. A component mounting system (10) comprising:
a holding tool (78) configured to hold a component (120);
a moving device (62) configured to move the holding tool (78);
an electromagnetic motor (70, 72) for lowering the holding tool (78) in order to mount the component (120) on a board (12);
a detection sensor (82) configured to detect contact of a component (120)
held by the holding tool (78) with a board (12); and
a control device (36), configured to perform a first mounting operation and a second mounting operation selectively, wherein
the first mounting operation is an operation in which a component (120) held by the holding tool (78) is mounted on the board (12) while executing foreign matter detection for detecting with the sensor (82) whether there is foreign matter present at a planned mounting position, and the second mounting operation is an operation in which a component (120) held by the holding tool (78) is mounted on the board (12) without executing the foreign matter detection, and wherein,
in the foreign matter detection an actual component height (HR) of the component (120) is calculated based on a detected value of an encoder of the electromagnetic motor (70, 72), a target component height (HM) is set in advance based on the height dimensions of the component (120) and
the component mounting system (10) is configured such that, if detection sensor (82) detects that a member has come in contact with the component (10), before actual component height (HR) is lowered to target component height (HM), it is determined that foreign matter (130) is present at the planned mounting position on the board (120);
wherein
with respect to the production work of the same board type, the control device (36) is configured to control the lowering speed of the holding tool (78) such that the time required for the production work of the board (12) using the first mounting operation is longer than the time required for the production work of the board (12) using the second mounting operation.

## Patentansprüche

1. Ein Komponentenmontagesystem (10) umfassend:
ein Haltewerkzeug (78), das konfiguriert ist, eine Komponente (120) zu halten;
eine Bewegungsvorrichtung (62), die konfiguriert ist, das Haltewerkzeug (78) zu bewegen;
einen elektromagnetischen Motor (70, 72) zum Absenken des Haltewerkzeugs (78), um die Komponente (120) auf einer Platte (12) zu montieren;
einen Erfassungssensor (82), der konfiguriert ist, den Kontakt einer von dem Haltewerkzeug (78) gehaltenen Komponente (120) mit der Platte (12) zu erfassen; und
eine Steuervorrichtung (36), die konfiguriert ist, selektiv einen ersten Montagevorgang und einen zweiten Montagevorgang durchzuführen, wobei
der erste Montagevorgang ein Vorgang ist, bei dem eine von dem Haltewerkzeug (78) gehaltene Komponente (120) auf der Platte (12) montiert wird, während eine Fremdkörperdetektion ausgeführt wird, um mit dem Erfassungssensor (82) zu detektieren, ob an einer geplanten Montageposition ein Fremdkörper vorhanden ist, und der zweite Montagevorgang ein Vorgang ist, bei dem eine von dem Haltewerkzeug (78) gehaltene Komponente (120) auf der Platte (12) montiert wird, ohne die Fremdkörperdetektion auszuführen, und wobei
bei der Fremdkörperdetektion eine Komponenten-Ist-Höhe (HR) der Komponente (120) auf Basis eines detektierten Wertes eines Encoders des elektromagnetischen Motors (70, 72) berechnet wird, eine Komponenten-Soll-Höhe (HM) auf Basis der Höhenabmessungen der Komponente (120) vorab eingestellt wird und
das Komponentenmontagesystem (10) konfiguriert ist, dass, wenn der Erfassungssensor (82) detektiert, dass ein Element mit der Komponente (10) in Berührung gekommen ist, bevor die Komponenten-Ist-Höhe (HR) auf die Komponenten-Soll-Höhe (HM) abgesenkt wird, festgestellt wird, dass ein Fremdkörper (130) an der geplanten Montageposition auf der Platte (120) vorhanden ist, wobei
in Bezug auf den Montagevorgang für jedes der Komponenten (120) die Steuervorrichtung (36) ferner konfiguriert ist, die Absenkgeschwindigkeit des Haltewerkzeugs (78) so zu steuern, dass die Komponente (120) auf der Platte (12) so montiert wird, dass die für den ersten Montagevorgang erforderliche Zeit länger ist als die für den zweiten Montagevorgang erforderliche Zeit.

2. Das Komponentenmontagesystem (10) gemäß Anspruch 1, wobei
das Komponentenmontagesystem (10) ferner einen Detektor (27) umfasst, der konfiguriert ist, eine Höhe an einer beliebigen Position der Platte (12) zu erfasst, und wobei
die Steuervorrichtung (36) die von dem Detektor (27) erfasste Höhe der Platte (12) verwendet, um den ersten Montagevorgang durchzuführen.

3. Das Komponentenmontagesystem (10) gemäß Anspruch 1 oder 2, wobei
der Erkennungssensor (82) ein berührungsloser Sensor ist.

4. Das Komponentenmontagesystem (10) gemäß einem der Ansprüche 1 bis 3, wobei
die Steuervorrichtung (36) konfiguriert ist, die für den Montagevorgang einer Komponente (120) des Haltewerkzeugs (78) erforderliche Zeit während des ersten Montagevorgangs zu ändern.

5. Ein Komponentenmontagesystem (10) umfassend:
ein Haltewerkzeug (78), das konfiguriert ist, eine Komponente (120) zu halten;
eine Bewegungsvorrichtung (62), die konfiguriert ist, das Haltewerkzeug (78) zu bewegen;
einen elektromagnetischen Motor (70, 72) zum Absenken des Haltewerkzeugs (78), um die Komponente (120) auf einer Platte (12) zu montieren;
einen Erfassungssensor (82), der konfiguriert ist, den Kontakt einer von dem Haltewerkzeug (78) gehaltenen Komponente (120) mit der Platte (12) zu erfassen; und
eine Steuervorrichtung (36), die konfiguriert ist, selektiv einen ersten Montagevorgang und einen zweiten Montagevorgang durchzuführen, wobei
der erste Montagevorgang ein Vorgang ist, bei dem eine von dem Haltewerkzeug (78) gehaltene Komponente (120) auf der Platte (12) montiert wird, während eine Fremdkörperdetektion ausgeführt wird, um mit dem Erfassungssensor (82) zu detektieren, ob an einer geplanten Montageposition ein Fremdkörper vorhanden ist, und der zweite Montagevorgang ein Vorgang ist, bei dem eine von dem Haltewerkzeug (78) gehaltene Komponente (120) auf der Platte (12) montiert wird, ohne die Fremdkörperdetektion auszuführen, und wobei
bei der Fremdkörperdetektion eine Komponenten-Ist-Höhe (HR) der Komponente (120) auf Basis eines detektierten Wertes eines Encoders des elektromagnetischen Motors (70, 72) berechnet wird, eine Komponenten-Soll-Höhe (HM) auf Basis der Höhenabmessungen der Komponente (120) vorab eingestellt wird und
das Komponentenmontagesystem (10) konfiguriert ist, dass, wenn der Erfassungssensor (82) detektiert, dass ein Element mit der Komponente (10) in Berührung gekommen ist, bevor die Komponenten-Ist-Höhe (HR) auf die Komponenten-Soll-Höhe (HM) abgesenkt wird, festgestellt wird, dass ein Fremdkörper (130) an der geplanten Montageposition auf der Platte (120) vorhanden ist, wobei
die Steuervorrichtung (36) konfiguriert ist, die Absenkgeschwindigkeit des Haltewerkzeugs (78) so zu steuern, dass die Zeit, die für die Herstellung der Platte (12) unter Verwendung des ersten Montagevorgangs benötigt wird, länger ist als die Zeit, die für die Herstellung der Platte (12) unter Verwendung des zweiten Montagevorgangs benötigt wird.

## Revendications

1. Système de montage de composants (10) comprenant :
un outil de maintien (78) configuré pour maintenir un composant (120) ;
un dispositif de déplacement (62) configuré pour déplacer l'outil de maintien (78) ;
un moteur électromagnétique (70, 72) pour abaisser l'outil de maintien (78) afin de monter le composant (120) sur une carte (12) ;
un capteur de détection (82) configuré pour détecter une entrée en contact d'un composant (120) qui est maintenu par l'outil de maintien (78) avec la carte (12) ; et
un dispositif de commande (36) configuré pour effectuer de façon simultanée une première opération de montage et une seconde opération de montage, dans lequel :
la première opération de montage est une opération selon laquelle un composant (120) qui est maintenu par l'outil de maintien (78) est monté sur la carte (12) tout en exécutant une détection de matière étrangère pour détecter, à l'aide du capteur de détection (82), s'il y a ou non de la matière étrangère présente au niveau d'une position de montage prévue, et la seconde opération de montage est une opération selon laquelle un composant (120) qui est maintenu par l'outil de maintien (78) est monté sur la carte (12) sans exécuter la détection de matière étrangère, et dans lequel :
lors de la détection de matière étrangère, une hauteur de composant réelle (HR) du composant (120) est calculée sur la base d'une valeur détectée d'un codeur du moteur électromagnétique (70, 72), et une hauteur de composant cible (HM) est définie à l'avance sur la base des dimensions de hauteur du composant (120) ; et
le système de montage de composants (10) est configuré de telle sorte que, si le capteur de détection (82) détecte qu'un élément est venu en contact avec le composant (120) avant que la hauteur de composant réelle (HR) n'ait été abaissée jusqu'à la hauteur de composant cible (HM), il est déterminé que de la matière étrangère (130) est présente au niveau de la position de montage prévue sur la carte (12) ;
dans lequel :
en ce qui concerne l'opération de montage pour chacun des composants (120), le dispositif de commande (36) est en outre configuré pour commander la vitesse d'abaissement de l'outil de maintien (78) de manière à monter le composant (120) sur la carte (12) de telle sorte que le temps qui est requis pour la première opération de montage soit plus long que le temps qui est requis pour la seconde opération de montage.

2. Système de montage de composants (10) selon la revendication 1, dans lequel :
le système de montage de composants (10) comprend en outre un détecteur (27) configuré pour détecter une hauteur au niveau de n'importe quelle position de la carte (12), et dans lequel :
le dispositif de commande (36) utilise la hauteur de la carte (12) qui est détectée par le détecteur (27) pour effectuer la première opération de montage.

3. Système de montage de composants (10) selon la revendication 1 ou la revendication 2, dans lequel :
le capteur de détection (82) est un capteur du type sans contact.

4. Système de montage de composants (10) selon l'une quelconque des revendications 1 à 3, dans lequel :
le dispositif de commande (36) est configuré pour modifier le temps qui est requis pour l'opération de montage d'un seul composant (120) de l'outil de maintien (78) pendant la première opération de montage.

5. Système de montage de composants (10) comprenant :
un outil de maintien (78) configuré pour maintenir un composant (120) ;
un dispositif de déplacement (62) configuré pour déplacer l'outil de maintien (78) ;
un moteur électromagnétique (70, 72) pour abaisser l'outil de maintien (78) afin de monter le composant (120) sur une carte (12) ;
un capteur de détection (82) configuré pour détecter une entrée en contact d'un composant (120) qui est maintenu par l'outil de maintien (78) avec une carte (12) ; et
un dispositif de commande (36) configuré pour effectuer de façon simultanée une première opération de montage et une seconde opération de montage, dans lequel :
la première opération de montage est une opération selon laquelle un composant (120) qui est maintenu par l'outil de maintien (78) est monté sur la carte (12) tout en exécutant une détection de matière étrangère pour détecter, à l'aide du capteur de détection (82), s'il y a ou non de la matière étrangère présente au niveau d'une position de montage prévue, et la seconde opération de montage est une opération selon laquelle un composant (120) qui est maintenu par l'outil de maintien (78) est monté sur la carte (12) sans exécuter la détection de matière étrangère, et dans lequel :
lors de la détection de matière étrangère, une hauteur de composant réelle (HR) du composant (120) est calculée sur la base d'une valeur détectée d'un codeur du moteur électromagnétique (70, 72), et une hauteur de composant cible (HM) est définie à l'avance sur la base des dimensions de hauteur du composant (120) ; et
le système de montage de composants (10) est configuré de telle sorte que, si le capteur de détection (82) détecte qu'un élément est venu en contact avec le composant (120) avant que la hauteur de composant réelle (HR) n'ait été abaissée jusqu'à la hauteur de composant cible (HM), il est déterminé que de la matière étrangère (130) est présente au niveau de la position de montage prévue sur la carte (12) ;
dans lequel :
en ce qui concerne le travail de production du même type de carte, le dispositif de commande (36) est configuré pour commander la vitesse d'abaissement de l'outil de maintien (78) de telle sorte que le temps qui est requis pour le travail de production de la carte (12) en faisant appel à la première opération de montage soit plus long que le temps qui est requis pour le travail de production de la carte (12) en faisant appel à la seconde opération de montage.
